(19) Europäisches Patentamt
European Patent Office
Office européen des brevets

(11) **EP 1 476 897 B1**

(12) **FASCICULE DE BREVET EUROPEEN**

(45) Date de publication et mention
de la délivrance du brevet:
**31.07.2013 Bulletin 2013/31**

(21) Numéro de dépôt: **03718864.6**

(22) Date de dépôt: **11.02.2003**

(51) Int Cl.:
***H01L 21/02*** *(2006.01)*

(86) Numéro de dépôt international:
**PCT/FR2003/000445**

(87) Numéro de publication internationale:
**WO 2003/069656 (21.08.2003 Gazette 2003/34)**

(54) **DIMINUTION IRREVERSIBLE DE LA VALEUR D UNE RESISTANCE EN SILICIUM POLYCRISTALLIN**

IRREVERSIBLE VERKLEINERUNG DES WIDERSTANDSWERTES EINES WIDERSTANDES AUS POLYKRISTALLINEM SILIZIUM

IRREVERSIBLE REDUCTION OF THE VALUE OF A POLYCRYSTALLINE SILICON RESISTOR

(84) Etats contractants désignés:
**DE FR GB IT**

(30) Priorité: **11.02.2002 FR 0201635**

(43) Date de publication de la demande:
**17.11.2004 Bulletin 2004/47**

(73) Titulaire: **STMicroelectronics S.A.
92120 Montrouge (FR)**

(72) Inventeurs:
• **WUIDART, Luc
F-83910 Pourrières (FR)**
• **Malherbe, Alexandre
13530 Trets (FR)**
• **BARDOUILLET, Michel
F-13790 Rousset (FR)**

(74) Mandataire: **de Beaumont, Michel
1, rue Champollion
38000 Grenoble (FR)**

(56) Documents cités:
**EP-A- 0 780 851    US-A- 5 187 559**

• **KATO K ET AL: "A PHYSICAL MECHANISM OF CURRENT-INDUCED RESISTANCE DECREASE IN HEAVILY DOPED POLYSILICON RESISTORS" IEEE TRANSACTIONS ON ELECTRON DEVICES, IEEE INC. NEW YORK, US, vol. 29, no. 8, août 1982 (1982-08), pages 1156-1161, XP000835577 ISSN: 0018-9383**
• **BABCOCK J A ET AL: "PRECISION ELECTRICAL TRIMMING OF VERY LOW TCR POLY-SIGE RESISTORS" IEEE ELECTRON DEVICE LETTERS, IEEE INC. NEW YORK, US, vol. 21, no. 6, juin 2000 (2000-06), pages 283-285, XP000951962 ISSN: 0741-3106**

**Description**

La présente invention concerne les résistances intégrées. Elle concerne, plus particulièrement, les résistances réalisées en silicium polycristallin dans un circuit intégré.

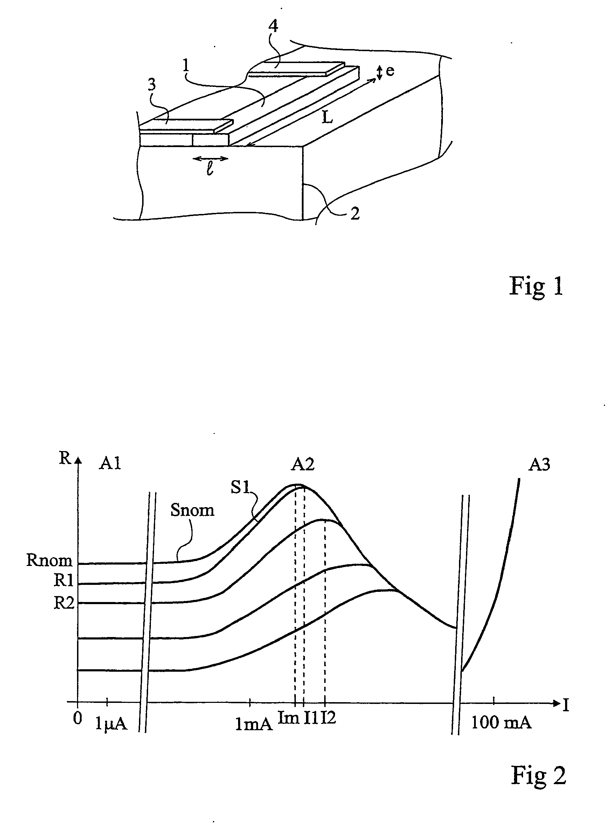

La figure 1 représente, par une vue partielle très schématique en perspective, un exemple de résistance en silicium polycristallin du type auquel s'applique la présente invention.

Une telle résistance 1 est constituée d'une piste (dite aussi barreau) en silicium polycristallin obtenue par gravure d'une couche déposée sur un substrat 2 isolant. Le substrat 2 est indifféremment directement constitué du substrat du circuit intégré ou est constitué d'une couche isolante formant un substrat isolant ou équivalent pour la résistance 1. La résistance 1 est connectée, par ses deux extrémités, à des pistes conductrices (par exemple, métalliques) 3 et 4 destinées à raccorder le barreau résistif aux autres éléments du circuit intégré en fonction de l'application. La représentation schématique de la figure 1 ne fait pas référence aux différentes couches isolantes et conductrices constituant généralement le circuit intégré. Pour simplifier, on s'est contenté de représenter le barreau résistif 1 posé sur le substrat isolant 2 et en contact, par les extrémités de sa face supérieure, avec les deux pistes métalliques 3 et 4. En pratique, les liaisons de l'élément résistif 1 aux autres composants du circuit intégré sont obtenues par des pistes plus larges en silicium polycristallin partant des extrémités du barreau 1 dans l'alignement de celui-ci. En d'autres termes, l'élément résistif 1 est généralement formé en rendant un tronçon d'une piste en silicium polycristallin plus étroit que le reste de la piste.

La résistance R de l'élément 1 est donnée par la formule suivante :

$$R = \rho(L/s),$$

où p désigne la résistivité du matériau (silicium polycristallin le cas échéant dopé) constituant la piste dans laquelle est gravé l'élément 1, où L désigne la longueur de l'élément 1, et où s désigne sa section, c'est-à-dire sa largeur 1 par son épaisseur e. La résistivité p de l'élément 1 dépend, entre autres, du dopage éventuel du silicium polycristallin le constituant. Dans certains cas, on recouvre l'élément de silicium polycristallin par une couche de métal, l'élément résistif combinant alors le silicium polycristallin et le métal sur-jacent.

Le plus souvent, lors de la réalisation d'un circuit intégré, on prévoit les résistances en faisant référence à une notion dite de résistance par carreau R□ (square resistance). Cette résistance par carreau se définit comme étant la résistivité du matériau divisée par l'épaisseur avec laquelle il est déposé. En reprenant la relation ci-dessus donnant la résistance d'un élément 1, la résistance est donc donnée par la relation :

$$R = R_{\square} * L/1.$$

Le quotient L/1 correspond à ce que l'on appelle le nombre de carreaux (square number) constituant l'élément résistif 1. Cela représente, vu de dessus, le nombre de carreaux de dimension donnée fonction de la technologie, mis côte à côte pour former l'élément 1.

La valeur de la résistance en silicium polycristallin est donc définie, à la fabrication, d'après les paramètres ci-dessus. Généralement, l'épaisseur e du silicium polycristallin est fixée par d'autres paramètres de fabrication du circuit intégré. Par exemple, cette épaisseur est fixée par l'épaisseur souhaitée pour les grilles des transistors MOS du circuit intégré.

Dans les technologies récentes, le recours à des résistances en silicium polycristallin est limité aux résistances devant être traversées, en fonctionnement, par des courants inférieurs à 100 μA. Pour des courants supérieurs, on utilise généralement une résistance de diffusion. Le silicium polycristallin est toutefois préféré à une diffusion de dopants, car on évite l'apparition de capacités parasites avec le substrat.

Il serait souhaitable de pouvoir modifier la valeur de la résistance d'un élément (1, figure 1) en silicium polycristallin après fabrication. Jusqu'à présent, la seule modification envisagée est une détérioration physique (fusion) pour utiliser un élément en silicium polycristallin fortement conducteur en guise de fusible. Pour cela, on impose un courant très élevé (de l'ordre d'un dixième d'ampère) dans l'élément en silicium polycristallin de façon à entraîner une détérioration physique de celui-ci et obtenir un circuit (fusible) ouvert.

La présente invention vise à obtenir une diminution de la valeur d'une résistance intégrée en silicium polycristallin après fabrication. L'invention vise, plus précisément, à obtenir une diminution de la valeur de la résistance, par rapport à sa valeur d'origine (nominale) issue de fabrication.

L'invention vise également à proposer une solution qui ne requiert pas d'appliquer de courants destructeurs dans le circuit et qui soit, par conséquent, compatible avec une diminution de la valeur de la résistance une fois le circuit en place dans son application.

Le document US-A-5 187 559 décrit un procédé de diminution de la valeur d'une résistance en silicium polycristallin consistant à appliquer un courant dont la densité est supérieure à un seuil. Le document "A physical mechanism of current-induced resistance decrease in heavily doped polysilicon resisters", IEEE Transactions on Electron Devices, vol. ED-29 (1982) Aug, No. 8, décrit un procédé similaire.

Pour atteindre ces objets et d'autres, la présente invention prévoit un procédé de diminution irréversible de la valeur d'une résistance intégrée en silicium polycristallin, consistant à soumettre temporairement la résistance à un courant de contrainte supérieur à un courant pour lequel la valeur de la résistance présente un maximum.

Selon un mode de mise en oeuvre de la présente invention, le courant de contrainte auquel est soumise la résistance est situé au-delà d'une plage de courants de fonctionnement d'un circuit intégré comprenant cette résistance.

Selon un mode de mise en oeuvre de la présente invention, on effectue les étapes suivantes :

augmenter pas à pas le courant dans la résistance ; et

mesurer, après chaque application d'un courant supérieur, la valeur de la résistance dans son environnement fonctionnel normal.

Selon un mode de mise en oeuvre de la présente invention, on utilise une table prédéterminée de correspondance entre le courant de contrainte et la résistance finale souhaitée pour appliquer à la résistance le courant de contrainte adapté.

Selon un mode de mise en oeuvre de la présente invention, le courant de contrainte est compris entre 1 et 10 milliampères.

Selon la présente invention, la concentration en dopant du silicium polycristallin est comprise entre $1.10^{13}$ et $1.10^{16}$ atomes par centimètre cube.

Ces objets, caractéristiques et avantages, ainsi que d'autres de la présente invention seront exposés en détail dans la description suivante de modes de mise en oeuvre et de réalisation particuliers faite à titre non limitatif en relation avec les figures jointes parmi lesquelles :

la figure 1 décrite précédemment représente, de façon partielle et très schématique, un exemple d'élément résistif en silicium polycristallin du type auquel s'applique la présente invention ;

la figure 2 illustre, par un réseau de courbes représentant la valeur de la résistance en fonction du courant dans un élément de silicium polycristallin, la mise en oeuvre du procédé de diminution irréversible de valeur d'une résistance selon l'invention ;

la figure 3 représente, de façon très schématique, un dispositif de commande en diminution irréversible de la valeur d'une résistance en silicium polycristallin ;

la figure 4 représente, de façon très schématique, un dispositif de commande en diminution irréversible de la valeur d'une résistance en silicium polycristallin ;

la figure 5 représente un premier exemple d'application d'une résistance selon la présente invention à la calibration d'un thermomètre électronique ; et

la figure 6 représente un deuxième exemple d'application d'une résistance selon la présente invention à un réseau résistif et capacitif.

Les mêmes éléments ont été désignés par les mêmes références aux différentes figures. Pour des raisons de clarté, seules les étapes du procédé et les éléments du dispositif qui sont nécessaires à la compréhension de l'invention ont été représentés aux figures et seront décrits par la suite. En particulier, la réalisation pratique d'une résistance en silicium polycristallin par dépôt et gravure n'a pas été détaillée, l'invention pouvant être mise en oeuvre sur une résistance formée de façon classique.

Une caractéristique de la présente invention est d'imposer temporairement, dans une résistance en silicium polycristallin dont on souhaite diminuer irréversiblement la valeur, un courant dit de contrainte pour lequel la résistance passe par une valeur maximale, ce courant étant au-delà de la plage de courants de fonctionnement normal de cette résistance. En d'autres termes, on diminue la résistivité du silicium polycristallin dans la plage de courants de fonctionnement, de façon stable et irréversible, en imposant dans l'élément résistif correspondant la circulation d'un courant au-delà de la plage de courants de fonctionnement.

Une autre caractéristique de l'invention est que le courant servant à diminuer la valeur de la résistance est, à la différence d'un élément fusible, non destructif pour l'élément en silicium polycristallin.

La figure 2 illustre, par un réseau de courbes donnant la résistance d'un élément en silicium polycristallin du type de celui représenté en figure 1 en fonction du courant le traversant, un mode de mise en oeuvre de la présente invention.

On suppose que le silicium polycristallin ayant servi à la fabrication de l'élément résistif 1 présente une résistivité nominale conférant à l'élément 1, pour les dimensions 1, L et e données, une valeur de résistance $R_{nom}$. Cette valeur nominale (d'origine) de la résistance correspond à la valeur prise de façon stable par l'élément résistif 1 dans la plage de courants de fonctionnement du système, c'est-à-dire généralement pour des courants inférieurs à 100 $\mu$A.

Selon l'invention, pour diminuer la valeur de la résistance et passer, par exemple, de façon irréversible et stable à une valeur R1 inférieure à $R_{nom}$, on applique aux bornes de l'élément résistif 1 un courant (par exemple I1), dit de contrainte, supérieur à un courant Im pour lequel la valeur de la résistance R de l'élément 1 est maximale sans toutefois être infinie. Comme l'illustre la figure 2, une fois que ce courant I1 a été appliqué à l'élément résistif 1, on obtient, dans la plage A1 de courants de fonctionnement du circuit intégré, une résistance stable de valeur R1. En fait, l'allure $S_{nom}$ de la résistance en fonction du courant est stable pour des courants relativement faibles (inférieurs à 100 $\mu$A). Cette allure se met à croître pour des courants sensiblement supérieurs de l'ordre de quelques milliampères, voire plus (plage A2). C'est dans cette plage de courants que l'allure Snom passe par un maximum pour la valeur Im. La résistance décroît ensuite progressivement. En figure 2, on a illustré une troisième plage A3 de courants correspondant à la plage généralement utilisée pour réaliser des fusibles. I1 s'agit de courants de l'ordre du dixième d'ampère où la résistance se met à croître brusquement jusqu'à devenir infinie. Par conséquent, on peut considérer que l'invention utilise la plage intermédiaire A2 de courants entre la plage de fonctionnement A1 et la plage destructrice A3, pour diminuer de façon irréversible la valeur de la résistance ou plus précisément de la résistivité de l'élément en silicium polycristallin.

En effet, une fois passé le maximum de l'allure Snom de la résistivité en fonction du courant, la valeur prise par la résistance dans la plage de courants de fonctionnement se trouve inférieure à la valeur $R_{nom}$. La nouvelle valeur, par exemple R1, dépend de la valeur la plus élevée du courant (ici, I1) qui a été appliqué pendant la phase de diminution irréversible. On notera en effet que la diminution irréversible opérée par l'invention s'effectue dans une phase spécifique, hors du fonctionnement normal (plage A1) du circuit intégré, c'est-à-dire hors du fonctionnement normal de la résistance.

Une fois que la valeur de la résistance en silicium polycristallin a été abaissée vers une valeur inférieure (par exemple R1 en figure 2), on peut encore procéder à une diminution irréversible de cette valeur. I1 suffit pour cela de dépasser le courant maximum I1 de la nouvelle allure S1 de la résistance en fonction du courant. Par exemple, on peut accroître la valeur du courant jusqu'à atteindre une valeur I2. Quand le courant est alors de nouveau diminué, on obtient une valeur R2 pour la résistance dans sa plage de fonctionnement normal. La valeur R2 est inférieure à la valeur R1 et, bien sûr, à la valeur $R_{nom}$.

On voit que toutes les allures de la résistance en fonction du courant se rejoignent sur la pente de décroissance de la valeur de la résistance, après être passées par le maximum de l'allure. Ainsi, pour un élément résistif donné (p, L, s), les courants I1, I2, etc. qui doivent être atteints, pour passer à une valeur de résistance inférieure, sont indépendants de la valeur de la résistance (Rnom, R1, R2) à partir de laquelle on provoque la diminution.

Ce qui a été exprimé ci-dessus comme valeur de résistance correspond en fait à une diminution de la résistivité du silicium polycristallin constituant l'élément résistif. Les inventeurs considèrent que l'on assiste à une modification stable de la structure cristalline du silicium polycristallin et que l'on assiste, en quelque sorte, à un fluage du matériau, la structure cristalline finale obtenue dépendant du courant maximum atteint.

Bien sûr, on veillera à ne pas dépasser la plage de courants de paramétrage A2 (de l'ordre de quelques milliampères) afin de ne pas risquer de détruire la résistance en silicium polycristallin. Cette précaution ne posera en pratique pas de problème dans la mesure où l'utilisation du silicium polycristallin pour constituer un fusible requiert des courants nettement plus élevés (de l'ordre du dixième d'ampère) qui ne sont pas disponibles une fois le circuit fabriqué.

La réalisation pratique d'une résistance en silicium polycristallin selon l'invention ne diffère pas de la réalisation d'une résistance classique. Partant d'un substrat isolant, on dépose une couche de silicium polycristallin que l'on grave en fonction des dimensions souhaitées pour la résistance. Comme l'épaisseur de silicium polycristallin déposée est généralement fixée par la technologie, les deux dimensions que l'on peut régler sont la largeur et la longueur. Généralement, on redépose un isolant sur le barreau de silicium polycristallin ainsi obtenu. Dans le cas d'une interconnexion en ligne, on aura modifié la largeur 1 par rapport aux pistes d'accès plus larges pour être fortement conductrices. Dans le cas d'un accès aux extrémités du barreau par le dessus comme cela est illustré en figure 1, on réalisera des vias dans l'isolant sur-jacent (non représenté) du barreau de silicium polycristallin pour connecter des pistes métalliques 3 et 4 de contact.

En pratique, pour disposer de la capacité de réglage de résistance la plus importante avec un courant de contrainte minimum, on cherchera à utiliser une épaisseur minimale et une largeur minimale pour les éléments résistifs. Dans ce cas, seule la longueur L conditionne la valeur nominale de la résistance une fois la structure du silicium polycristallin fixée. Le dopage éventuel du silicium polycristallin, quel que soit son type, n'entrave pas la mise en oeuvre de l'invention. La seule différence liée au dopage est la résistivité nominale avant contrainte et les résistivités obtenues pour des courants de contraintes donnés. En d'autres termes, pour un élément de dimensions données, cela conditionne le point de départ de la valeur de la résistance, et par voie de conséquence, les valeurs de résistance obtenues pour des courants de contrainte donnés.

Pour passer de la valeur nominale à une valeur de résistance ou résistivité inférieure, ou pour passer d'une valeur donnée (inférieure à la valeur nominale) à une valeur encore inférieure, on peut selon l'invention utiliser plusieurs méthodes.

Selon un premier mode de mise en oeuvre, on fait croître progressivement (pas à pas) le courant dans la résistance. Après chaque application d'un courant supérieur, on revient dans la plage de courants de fonctionnement et on mesure la valeur de la résistance. Tant que le point Im de courant n'est pas atteint, cette valeur de résistance restera à la valeur $R_{nom}$. Dès que le point Im en courant est dépassé, on change de courbe (allure S) et la valeur mesurée lorsque l'on repasse sur les courants de fonctionnement devient une valeur inférieure à la valeur $R_{nom}$. Si cette nouvelle valeur convient, on en reste là. Dans le cas contraire, on réapplique des courants supérieurs pour dépasser la nouvelle valeur maximale de l'allure courante. Dans ce cas, il n'est pas nécessaire de repartir des courants minimaux comme lorsque l'on démarre de la résistance nominale. En effet, la valeur du courant pour laquelle la résistance va de nouveau diminuer est forcément supérieure à la valeur du courant de contrainte I1 appliqué pour passer sur l'allure courante. La détermination du pas à appliquer est à la portée de l'homme du métier et n'est pas critique en ce qu'elle conditionne essentiellement le nombre de diminutions possibles. Plus le pas est élevé, plus les sauts entre les valeurs seront importants.

Selon un deuxième mode de mise en oeuvre, on prédétermine, par exemple par mesures, les différents courants à appliquer pour passer des différentes valeurs de résistance à des valeurs inférieures. Cette prédétermination tient compte bien entendu de la nature du silicium polycristallin utilisé ainsi que préférentiellement de la résistance par carreau c'est-à-dire de la résistivité du matériau et de l'épaisseur dans laquelle il est déposé. En effet, comme les allures illustrées par la figure 2 peuvent également être lues comme allure de la résistance par carreau, on est en mesure de transposer les valeurs calculées aux différentes résistances d'un circuit intégré définies par les largeurs et longueurs des tronçons résistifs. Selon ce deuxième mode de mise en oeuvre, on est alors en mesure de prédéterminer la valeur du courant de contrainte à appliquer à l'élément résistif pour diminuer, de façon irréversible et stable, sa valeur.

Les deux modes de mise en oeuvre ci-dessus sont bien entendu combinables. Par exemple, on commence par appliquer un courant de contrainte issu d'une table avant d'affiner la diminution irréversible pas à pas.

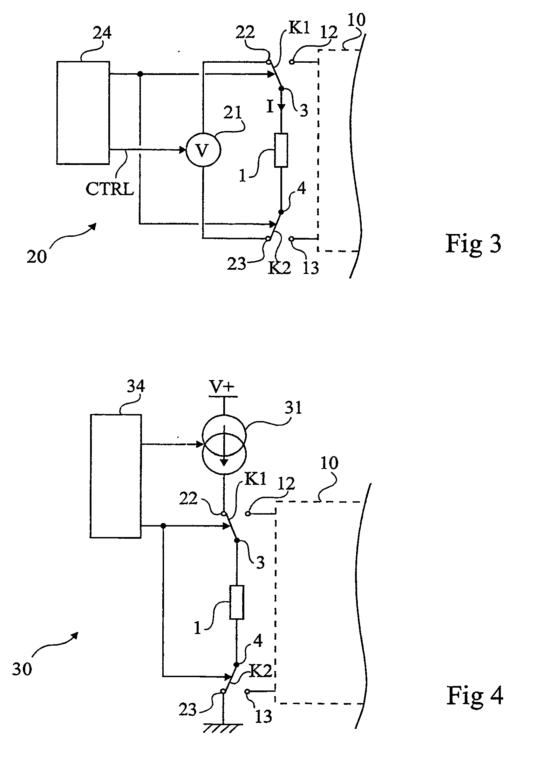

Selon l'invention, la diminution irréversible de la résistance ou résistivité peut être effectuée après fabrication lorsque le circuit est dans son environnement fonctionnel. En d'autres termes, la résistance intégrée peut être associée à un dispositif de commande en diminution de sa valeur qui sera décrit par la suite en relation avec les figures 3 et 4.

Le changement de courbes, c'est-à-dire la diminution de la valeur de résistance en fonctionnement normal est quasi immédiate dès que le courant de contrainte correspondant est appliqué. Par quasi-immédiat, on entend une durée de quelques dizaines voir centaines de microsecondes qui suffisent pour appliquer la contrainte correspondante au barreau de silicium polycristallin et diminuer la valeur de sa résistance. Cette valeur empirique dépend de la taille (physique) du barreau. On pourra choisir une durée de quelques millisecondes par sécurité. De plus, on peut considérer que, une fois la durée minimale atteinte, toute durée supplémentaire d'application du courant de contrainte ne modifie pas, au moins au premier ordre, la résistance atteinte. En outre, même si dans une application particulière on considère ne pas pouvoir négliger l'influence de la durée d'application de la contrainte, les deux modes préférés de mise en oeuvre (prédéterminer des valeurs de contraintes en durée et en intensité, ou progression pas à pas jusqu'à la valeur souhaitée) sont parfaitement compatibles avec la prise en compte de la durée d'application de la contrainte.

A titre d'exemple particulier de mise en oeuvre, on a réalisé une résistance en silicium polycristallin dopée N+ ayant une section de 0,225 micromètre carré (1 = 0,9 $\mu$m, e = 0,25 $\mu$m) et une longueur L de 45 micromètres. Avec le silicium polycristallin utilisé et le dopage correspondant, la résistance nominale était d'environ 6300 Ohms. Cela correspond à une résistance par carreau d'environ 126 Ohms (50 carreaux). En appliquant à cette résistance un courant supérieur à trois milliampères, on a provoqué une diminution de sa valeur, stable pour un fonctionnement sous des courants allant jusqu'à 500 microampères. Avec un courant de 3,1 milliampères, la valeur de la résistance a été abaissée à environ 4500 Ohms. En appliquant à la résistance un courant de 4 milliampères, on a diminué la valeur de la résistance jusqu'environ 3000 Ohms. Les valeurs obtenues de résistances ont été les mêmes pour des durées de contraintes allant de 100 microsecondes à plus de 100 secondes.

Bien entendu, les exemples ci-dessus ainsi que les ordres de grandeurs donnés de courants et de résistances pour les différentes plages concernent les technologies actuelles. Les courants des plages A1, A2 et A3 pourront être différents (inférieurs) pour des technologies plus avancées et peuvent être transposés à des densités de courant. Le principe de l'invention n'en est pas modifié. On a toujours trois plages et on utilise la plage intermédiaire pour forcer la diminution de résistivité.

La figure 3 représente un dispositif de diminution irréversible de la valeur d'une résistance 1 en silicium polycristallin. La résistance 1 est utilisée par un circuit 10 illustré partiellement et en pointillés en figure 3. Le contenu de ce circuit 10 pourra être quelconque pourvu de requérir une résistance dont on souhaite pouvoir diminuer la valeur.

Le dispositif de commande 20 comporte ici une source de tension 21 (V) commandable pour imposer un courant dans la résistance 1. Pour sélectionner un mode de connexion de la résistance 1 entre la connexion de fonctionnement normal au circuit 10 et une connexion temporaire au circuit 20, les deux bornes 3 et 4 de la résistance 1 sont reliées chacune à un interrupteur K1, K2 (par exemple, un transistor MOS) de raccordement soit aux bornes 22, 23 de la source de tension 21, soit aux bornes 12, 13 d'accès au circuit 10. Les interrupteurs K1 et K2 sont commandés simultanément par un circuit 24 fournissant également un signal CTRL de commande de la valeur appliquée par la source 21.

Le fonctionnement du circuit 20 illustré par la figure 3 se comprend aisément suite à ce qui a été exposé dans la mise en oeuvre du procédé de l'invention. En fonctionnement normal, les interrupteurs K1 et K2 raccordent la résistance 1 au circuit applicatif 10. Lorsque l'on souhaite diminuer sa valeur de façon irréversible, on commence par connecter les bornes 3 et 4 de la résistance 1 aux bornes 22 et 23 de la source de tension V. Puis, on applique une tension adaptée pour que le courant I la traversant dépasse le maximum de l'allure correspondante (figure 2). Enfin, on reconnecte la résistance aux bornes 12 et 13 du circuit 10 grâce aux commutateurs K1 et K2. De préférence, la position de repos des commutateurs K1 et K2 sera une connexion aux bornes du circuit 10 afin d'éviter une consommation permanente du circuit de commande en dehors des phases de contrainte pour diminution irréversible de la valeur de la résistance. La déconnexion de la résistance au circuit 10 pendant les phases de contrainte en courant permet d'éviter tout risque d'endommager ce circuit 10 par l'application d'un courant de quelques milliampères nécessaire pour modifier la valeur de la résistance.

On a décrit le recours à deux interrupteurs pour mieux faire ressortir le fonctionnement. En pratique, et notamment si la commande en paramétrage est intégrée avec l'application, on se contentera d'un seul interrupteur, l'autre borne de la résistance étant reliée à une borne (d'alimentation ou de masse) commune aux circuits de paramétrage et d'application.

La figure 4 représente un deuxième circuit 30 de commande en diminution irréversible de la valeur d'une résistance 1 en silicium polycristallin. Le mode de réalisation de la figure 4 diffère de celui de la figure 3 en ce que la contrainte appliquée à la résistance 1 est effectuée au moyen d'une source de courant commandable 31 et non d'une source de tension. Dans le mode de réalisation de la figure 4, les connexions de la résistance 1 en fonctionnement sont inchangées par rapport au mode de réalisation de la figure 3, c'est-à-dire qu'elle est connectée aux bornes 12 et 13 d'un circuit applicatif 10. La résistance 1 est toujours connectée à ces bornes 12 et 13 par des interrupteurs K1 et K2. Toutefois, la connexion de commande en diminution de valeur, c'est-à-dire la connexion aux bornes 22 et 23, a ici pour effet de placer la résistance 1 en série avec la source de courant commandable 31. La source 31 est commandée par un circuit 34 synchronisant également la commutation des interrupteurs K1 et K2.

Un avantage de la présente invention est qu'elle permet une diminution commandable, stable et irréversible, de la valeur d'une résistance en silicium polycristallin.

Un autre avantage de l'invention est que les courants requis pour procéder à la diminution irréversible de la valeur de la résistance sont compatibles avec les éléments de commande classiquement intégrés avec celle-ci.

Un autre avantage de l'invention est que la modification irréversible de la valeur de la résistance n'est pas destructrice et ne risque donc pas d'endommager d'autres parties du circuit. Cela permet notamment de prévoir une diminution de la valeur de la résistance après fabrication, et même au cours de sa vie dans son circuit applicatif.

Un autre avantage de la présente invention est que la modification de la valeur de la résistance obtenue est invisible optiquement à la différence d'une destruction. L'invention peut donc être utilisée dans des applications dites sécuritaires, c'est-à-dire où l'on cherche à masquer le fonctionnement d'un circuit intégré ou de certains codes qui lui sont associés.

On notera que l'invention est aisément transposable d'une technologie à une autre.

L'invention trouve de multiples applications dans tout domaine où l'on souhaite provoquer une diminution irréversible de la valeur d'une résistance dans un circuit intégré.

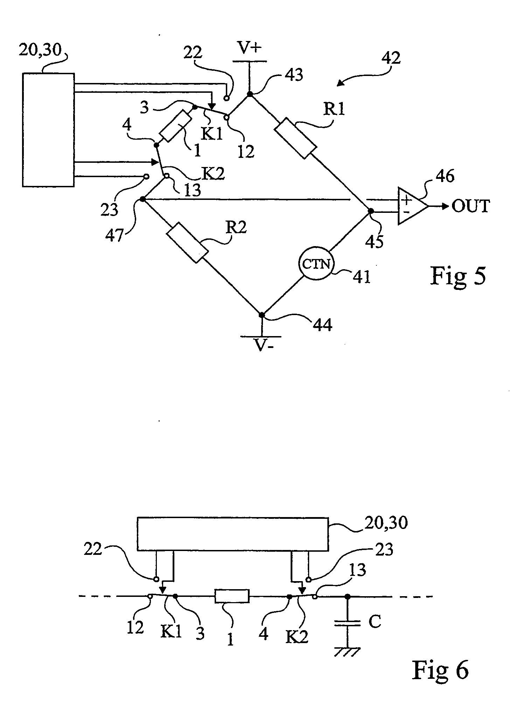

La figure 5 représente, de façon schématique, un premier exemple d'application de la présente invention à l'étalonnage d'une sonde de température.

Selon cet exemple, un capteur constitué d'une résistance 41 à coefficient de température négatif (CTN) est connecté dans une structure en pont dont les différentes branches comprennent d'autres résistances. Parmi celles-ci, la résistance opposée au capteur 41 est une résistance commandable 1 selon l'invention. Les deux autres résistances sont des résistances R1 et R2 standard en ce sens que, même s'il s'agit de résistances en silicium polycristallin, elles ne sont pas commandables en diminution selon l'invention. Le pont 42 est connecté entre deux bornes 43 et 44 d'application d'une tension d'alimentation, c'est-à-dire des connexions à des potentiels V+ et V- par exemple, respectivement positif et de masse. Dans l'exemple de la figure 5, une première branche du pont est constituée de l'association en série, entre les bornes 43 et 44, de la résistance R1 et du capteur 41, le point milieu étant connecté à une première entrée 45, par exemple inverseuse, d'un amplificateur différentiel 46 de mesure. Une deuxième branche du pont est constituée de l'association en série, entre les bornes 43 et 44, de la résistance commandable 1 et de la résistance R2. Une première borne de la résistance commandable 1, c'est-à-dire la borne 12 de l'interrupteur K1, est reliée à la borne d'alimentation positive 43. La borne 13 de l'interrupteur K2, c'est-à-dire la deuxième borne en fonctionnement de la résistance 1, est reliée à la borne 47 non inverseuse de l'amplificateur 46 et à une première borne de la résistance R2, dont l'autre borne est reliée à l'alimentation négative 44. La sortie de l'amplificateur 46 fournit un signal OUT représentatif de la mesure de la température effectuée au moyen du capteur 41. Selon qu'il s'agit d'un amplificateur monté ou non en comparateur, la mesure donne soit une détection par rapport à un seuil de température, soit une différence analogique. La résistance 1 peut être commandée au moyen d'un circuit en tension 20 ou en courant 30. Ce circuit a été illustré de façon globale par un bloc en figure 5. La résistance 1 sert à étalonner le capteur en température, par exemple à l'aide d'un thermomètre de référence. La résistance 1 remplace ici un réseau de résistances commutables d'un circuit d'étalonnage classique.

Dans cette application, on devra simplement veiller à prévoir une résistance ayant une valeur nominale d'origine suffisamment importante pour garantir que l'étalonnage ne requiert qu'une diminution de sa valeur.

La figure 6 représente un deuxième exemple d'application de la présente invention à un réseau RC. Dans cet exemple, on retrouve une résistance commandable 1 selon l'invention associée à un dispositif de commande 20 ou 30 tel qu'illustré par les figures 3 et 4. Ainsi, la résistance 1 est encadrée par deux interrupteurs K1 et K2, la borne 12 de l'interrupteur K1 constitue ici la borne d'entrée du circuit RC. La borne 13 de l'interrupteur K2 est reliée à une première électrode d'un condensateur C dont l'autre électrode est reliée à la masse. La borne 13 constitue la sortie de la cellule RC. Le fonctionnement d'une cellule telle qu'illustrée par la figure 6 est parfaitement classique. La résistance commandable 1 de l'invention permet, de façon irréversible par diminution de sa valeur, une diminution de la constante de temps de la cellule RC.

D'autres applications de l'invention pourront être envisagées. Par exemple, et de façon non limitative, on pourra prévoir, au moyen d'une résistance commandable selon l'invention, de modifier le facteur de qualité d'un transpondeur électromagnétique en modifiant la résistance du circuit résonant série le constituant. Plus généralement, l'invention peut être utilisée comme élément de mémorisation "analogique", la grandeur stockée étant dépendante de la valeur de la résistance.

Selon un autre exemple, on peut diminuer la valeur de la résistance au fur et à mesure des utilisations d'un circuit intégré jusqu'à atteindre une valeur limite correspondant à un nombre maximal d'utilisations.

De préférence, le silicium polycristallin constitutif des éléments résistifs de l'invention n'est pas soumis à un dépôt métallique classiquement utilisé pour diminuer la résistance des grilles des transistors MOS.

Selon un exemple de mise en oeuvre particulier de l'invention, le courant de contrainte est compris entre 1 et 10 milliampères.

La concentration en dopant du silicium polycristallin est comprise entre $1.10^{13}$ et $1.10^{16}$ atomes par centimètre cube.

A titre d'exemple particulier, on a réalisé des résistances en silicium polycristallin ayant les caractéristiques nominales suivantes.

| type de silicium polycristallin | cristallin | cristallin | amorphe |
|---|---|---|---|
| technologie | 0,18 $\mu$m, | 0,18 $\mu$m | 0,35 $\mu$m |
| largeur | 0,5 $\mu$m | 0,5 $\mu$m | 0,9 $\mu$m |
| longueur | 3,4 $\mu$m | 80 $\mu$m | 45 $\mu$m |
| épaisseur | 200 nm | 200 nm | 250 $n$m |
| résistance/carreau | 80 ohms/□ | 100 ohms/□ | 115 ohms/□ |
| résistance globale | 556 ohms | 16000 ohms | 5750 ohms |
| concentration de dopant (atomes/cm3) | As = $6.10^{15}$ | As = $5.10^{15}$ | P = $1.10^{13}$ As = $4.10^{15}$ |
| courant de contrainte pour diminuer la résistance de moitié | 5,5 mA | 4,8 mA | 2,75 mA |

Bien entendu, la présente invention est susceptible de diverses variantes et modifications qui apparaîtront à l'homme de l'art. En particulier, les dimensionnements des résistances en silicium polycristallin en vue d'obtenir une valeur nominale dépendent de l'application et sont à la portée de l'homme du métier à partir des indications fonctionnelles données ci-dessus.

De plus, d'autres applications et circuits de commande que ceux exposés ci-dessus à titre d'exemple pourront être envisagés. En particulier, la commande en diminution de la valeur de la résistance effectuée selon l'invention peut être volontaire ou automatique selon les applications.

En outre, le nombre de résistances commandables utilisables dans un circuit intégré n'est pas limité. Elles peuvent même, le cas échéant, partager un même circuit de commande.

Enfin, bien que le circuit de commande soit préférentiellement intégré avec la résistance, ce qui facilite notamment la mise en oeuvre du procédé au cours de la vie de la résistance, il n'est pas exclu d'utiliser un circuit séparé pour forcer le courant de contrainte dans la résistance. A cet égard, les valeurs des contraintes en tension ou en courant pour la mise en oeuvre de l'invention sont à la portée de l'homme du métier à partir des indications fonctionnelles données ci-dessus.

**Revendications**

1. Procédé de diminution irréversible de la valeur d'une résistance intégrée en silicium polycristallin dans lequel la résistance est soumise temporairement à un courant de contrainte, **caractérisé en ce que** ce courant de contrainte est choisi pour être supérieur à un courant (Im) pour lequel la valeur de la résistance présente un maximum, et inférieur à un courant de l'ordre du dixième d'ampère pour lequel la valeur de la résistance se met à croître brusquement jusqu'à devenir infinie, la concentration en dopant du silicium polycristallin étant comprise entre $1.10^{13}$ et $1.10^{16}$ atomes par centimètre cube.

2. Procédé selon la revendication 1, dans lequel le courant de contrainte auquel est soumise la résistance est situé au-delà d'une plage de courants de fonctionnement d'un circuit intégré comprenant cette résistance.

3. Procédé selon la revendication 1 ou 2, comprenant les étapes suivante :

   augmenter pas à pas le courant dans la résistance ; et
   mesurer, après chaque application d'un courant supérieur, la valeur de la résistance dans son environnement fonctionnel normal.

4. Procédé selon l'une quelconque des revendications 1 à 3, dans lequel une table prédéterminée de correspondance entre le courant de contrainte et la résistance finale souhaitée est utilisée pour appliquer à la résistance le courant de contrainte adapté.

5. Procédé selon l'une quelconque des revendications 1 à 4, dans lequel le courant de contrainte est compris entre 1 et 10 milliampères.

**Patentansprüche**

1. Ein Verfahren zur irreversiblen Verringerung eines Wertes eines integrierten Polysilizium-Widerstands, wobei der Widerstand zeitweise einem Einschränkungsstrom unterworfen wird, **dadurch gekennzeichnet, dass** der Einschränkungsstrom größer ausgewählt wird als ein Strom (Im) für den der Wert des Widerstands ein Maximum zeigt, und niedriger als ein Strom von ungefähr einem Zehntel Ampere für den der Widerstandswert beginnt scharf anzusteigen bis er unendlich wird, wobei die Dotiermittelkonzentration des Polysiliziums zwischen $1x10^{13}$ und $1x10^{16}$ Atome/cm$^3$ aufweist.

2. Verfahren nach Anspruch 1, wobei der Einschränkungsstrom, dem der Widerstand ausgesetzt wird, oberhalb eines Betriebsstrombereichs einer integrierten Schaltung, die diesen Widerstand aufweist, liegt.

3. Verfahren nach Anspruch 1 oder 2, wobei die folgenden Schritte vorgesehen sind:

   Vergrößerung des Stromes in dem Widerstand Schritt um Schritt; und
   Messen, nach jedem Anlegen eines größeren Stroms, den Wert des Widerstands in seiner normalen funktionellen Umgebung.

4. Verfahren nach einem der Ansprüche 1 bis 3, wobei eine vorbestimmte Entsprechungstabelle zwischen dem Einschränkungsstrom und dem Soll-Endwiderstand ausgegeben wird, um den geeigneten Einschränkungsstrom an den Widerstand anzulegen.

5. Verfahren nach einem der Ansprüche 1 bis 4, wobei der Einschränkungsstrom zwischen 1 und 10 mA liegt.

**Claims**

1. A method for irreversibly decreasing a value of an integrated polysilicon resistor, wherein the resistor is temporarily submitted to a constraint current **characterized in that** said constraint current is selected to be greater than a current (Im) for which the value of the resistor exhibits a maximum, and lower than a current of about a tenth of ampere for which the resistor value starts increasing sharply until becoming infinite, the dopant concentration of the polysilicon being comprised between $1 \times 10^{13}$ and $1 \times 10^{16}$ atoms/cm$^3$.

2. The method of claim 1, wherein the constraint current to which the resistor is submitted is beyond an operating current range of an integrated circuit comprising this resistor.

3. The method of claim 1 or 2, comprising the steps of:

increasing step by step the current in the resistor; and
measuring, after each application of a greater current, the value of the resistance in its normal functional environment.

4. The method of any of claims 1 to 3, wherein a predetermined table of correspondence between the constraint current and the desired final resistance is issued to apply the adapted constraint current to the resistor.

5. The method of any of claims 1 to 4, wherein the constraint current is comprised between 1 and 10 mA.

Fig 1

Fig 2

Fig 3

Fig 4

Fig 5

Fig 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5187559 A

**Littérature non-brevet citée dans la description**

- A physical mechanism of current-induced resistance decrease in heavily doped polysilicon resisters. *IEEE Transactions on Electron Devices,* Août 1982, vol. ED-29 (8